# EUROPÄISCHE PATENTSCHRIFT

(11) **EP 1 350 252 B1**
(45) Veröffentlichungstag und Bekanntmachung des Hinweises auf die Patenterteilung: **16.06.2004**
(21) Anmeldenummer: 01985373.8
(22) Anmeldetag: 06.12.2001
(51) Int. Cl.: G11C 16/10

(54) **VERFAHREN ZUM EINSPEICHERN EINER DATENMENGE IN EINEN ZIELSPEICHERBEREICH UND SPEICHERSYSTEM**
METHOD FOR STORING A VOLUME OF DATA IN A TARGET MEMORY AREA AND A MEMORY SYSTEM
PROCEDE PERMETTANT D'ENREGISTRER EN MEMOIRE UN FLOT DE DONNEES DANS UNE ZONE MEMOIRE CIBLE ET SYSTEME DE MEMOIRE

(30) Priorität: 02.03.2001 DE 10110153
(43) Veröffentlichungstag der Anmeldung: 08.10.2003
(73) Patentinhaber: Infineon Technologies AG, 81669 München (DE)
(72) Erfinder: BRUECKLMAYR, Franz-Josef, 86916 Kaufering (DE); MAY, Christian, 81677 Muenchen (DE); POCKRANDT, Wolfgang, 85293 Reichertshausen (DE); SEDLAK, Holger, 82054 Sauerlach (DE)
(74) Vertreter: Schoppe, Fritz, Dipl.-Ing.
(86) Internationale Anmeldenummer: PCT/EP2001/014348
(87) Internationale Veröffentlichungsnummer: WO 2002/071409

(56) Entgegenhaltungen:
- EP-A- 0 489 204
- US-A- 4 433 395
- PATENT ABSTRACTS OF JAPAN vol. 2000, no. 14, 5. März 2001 (2001-03-05) & JP 2000 305862 A (MITSUBISHI ELECTRIC CORP), 2. November 2000 (2000-11-02)

## Beschreibung

Die vorliegende Erfindung bezieht sich auf das Abspeichern von Informationen und insbesondere auf das sichere Abspeichern von Informationen in einer fehleranfälligen Umgebung.

Beim nicht-flüchtigen Abspeichern von Informationen kann es zu Datenverlusten oder sogar zur willkürlichen Veränderung von Daten kommen. Da der Abspeichervorgang, der allgemein in einem Löschen der alten Informationen und einem Schreiben der neuen Informationen besteht, sich über einen relativ großen Zeitraum vollzieht, kann es insbesondere dann zu Störungen kommen, wenn beispielsweise Spannungseinbrüche bei der Versorgung des Speicherchips, bei der Versorgung von Busleitungen oder bei der Versorgung von dem Speicher, aus dem die abzuspeichernden Daten kommen, auftreten.

Kommt es während der Zeit, die zu einem nicht-flüchtigen Abspeichern benötigt wird, zu Störungen, so wird der Speichervorgang nicht korrekt ausgeführt, und das Ergebnis hängt von der Art und Weise der Ausführung der Speicherungen oder, anders ausgedrückt, von dem Programmierbedingungen und der Art und dem Zeitpunkt der Störungen ab.

Das U.S.-Patent Nr. 4,922,456 bezieht sich auf ein Verfahren zum Reduzieren der Abnutzung in einem nicht-flüchtigen Speicher mit einem Doppelpuffer. Bevor eine Schreib-Operation durchgeführt wird, werden die abzuspeichernden Informationen in einen Doppelpuffer geschrieben, um im Falle einer Störung die Schritte rekonstruieren zu können, die während des Schreibens auszuführen sind. Eine Flag wird gesetzt, die anzeigt, daß der Doppelpuffer gültig ist. Dann werden die Daten aus dem Doppelpuffer an die entsprechenden Positionen eines nicht-flüchtigen Speichers geschrieben. Schließlich wird die Flag gelöscht, so daß das Speicherverwaltungssystem weiß, daß nunmehr nicht mehr die Daten in dem Doppelpuffer gültig sind, sondern die Daten in dem nicht-flüchtigen Speicher.

Solche Verfahren, wie sie beispielhaft in dem U.S.-Patent Nr. 4,922,456 offenbart sind, benutzen parallele Speicherbereiche, in denen die Informationen alternierend gespeichert sind, so daß während des Speichervorgangs immer der Ausgangszustand erhalten bleibt. Mit Flags wird dabei der Fortschritt des Programmiervorgangs festgehalten. Diese Flags bezeichnen immer den Speicherbereich mit den augenblicklich gültigen Informationen. Das Setzen von nicht-flüchtigen Flags bedingt wieder nicht-flüchtige Programmiervorgänge, die gegen Störungen gesichert werden müssen. Der gesamte Ablauf setzt sich also aus einer ganzen Reihe von nicht-flüchtigen Speichervorgängen zusammen, die einen erheblichen Zeitaufwand bedingen. Außerdem wird relativ spät der Punkt erreicht, bei dem die neuen Informationen so vorliegen, daß sie nach dem Abklingen einer Störung als Ausgangsbasis für eine Korrekturprozedur genutzt werden können. Der Vorgang durchläuft weitgehend Schritte, die bei einer Störung nur dazu dienen, die alten Informationen zu retten. Darüber hinaus darf auch der Aufwand zum Programmieren der Flags etc. nicht übersehen werden.

Die EP 0 489 204 B1 offenbart eine Datenspeichervorrichtung, wie z. B. ein Plattenlaufwerk oder ein Bandlaufwerk, welche mit neuem Programmcode umprogrammiert werden können. Zumindest ein Teil des nicht-flüchtigen Speichers der Datenspeichervorrichtung ist ein Flash-Speicher, wobei das Speicherverwaltungssystem ausgebildet ist, um zunächst einen neuen Programmcode in einem RAM-Datenpuffer zu speichern. Dann wird festgestellt, ob der gesamte neue Programmcode in dem Datenpuffer empfangen und gespeichert worden ist. Hierauf wird der Flash-Speicher gelöscht, woraufhin der neue Programmcode aus dem Datenpuffer in den Flash-Speicher übertragen wird.

Dieses Konzept ist gegenüber dem Abspeichern unter Verwendung von Flags dahingehend vorteilhaft, daß solche nicht mehr benötigt werden. Problematisch ist jedoch, daß der RAM-Puffer ein flüchtiger Speicher ist, so daß in der Zeitspanne, in der die Daten in dem RAM-Puffer gehalten werden, ein Datenverlust aufgrund von Spannungsschwankungen bzw. Spannungseinbrüchen am RAM-Puffer auftreten kann. Daher muß gemäß EP 0 489 204 B1 vor dem Schritt des Übertragens des neuen Programmcodes aus dem Datenpuffer in den Flash-Speicher ein weiterer Überprüfungsschritt durchgeführt werden, um feststellen zu können, ob die Daten während ihrer Zeit im RAM-Puffer beschädigt worden sind oder nicht. Dieser Überprüfungsschritt bzw. diese Überprüfungsschritte führen wieder zu einem erhöhten Aufwand und damit zu einem erhöhten Zeitbedarf beim Speichern von Informationen oder, alternativ, zu einem RAM-Speicher mit besonders gesicherter Spannungsversorgung, was wiederum zeitaufwendig, teuer und oftmals schwer in ein Gesamtsystem zu integrieren ist. Darüber hinaus müssen Uberprüfungsalgorithmen für die Daten erstellt werden.

Die Aufgabe der vorliegenden Erfindung besteht darin, ein Konzept zum sicheren und wenig aufwendigen Übertragen von Informationen von einem Speichermedium zu einem anderen Speichermedium zu schaffen.

Diese Aufgabe wird durch ein Verfahren zum Einspeichern einer Datenmenge in einen Zielspeicherbereich nach Patentanspruch 1 oder durch ein Speichersystem nach Patentanspruch 9 gelöst.

Der vorliegenden Erfindung liegt die Erkenntnis zugrunde, daß der Puffer als nicht-flüchtiger Puffer ausgeführt sein muß, um sicherzustellen, daß die in dem Puffer gespeicherten Daten während ihrer "Zwischenlagerung" nicht beschädigt werden. Erfindungsgemäß wird zunächst die zu übertragende Datenmenge in einem nicht-flüchtigen Pufferspeicherbereich abgespeichert. Hierauf wird überprüft, ob die Daten erfolgreich in dem nicht-flüchtigen Pufferspeicherbereich abgespeichert sind.

Erst dann, wenn der Schritt des Überprüfens ein positives Ergebnis liefert, wird der Zielspeicherbereich gelöscht, in dem die vorbestimmte Menge von Daten eingespeichert werden soll. Dies bedeutet, daß die alten Daten erst dann gelöscht werden, wenn sichergestellt ist, daß die neuen Daten unbeschädigt in dem nicht-flüchtigen Puffer angekommen sind. Ein Spannungsausfall führt an keiner Stelle zu einem Totaldatenverlust, da sowohl die alten Daten, die in dem Zielspeicherbereich gespeichert sind, als auch die neuen Daten, die in dem Puffer gespeichert sind, gegen Spannungsausfälle gesichert sind. Die alten Daten werden erst gelöscht, wenn die neuen Daten im Puffer sind.

Dann, nach dem Schritt des Löschens des Zielspeicherbereichs werden die Daten von dem nicht-flüchtigen Pufferspeicherbereich in den Zielspeicherbereich übertragen. Dann sind die neuen Daten im Zielspeicherbereich verfügbar und stehen für einen Interessenten zur Verfügung. Erfindungsgemäß wird nun jedoch am Ende des Zyklus der nicht-flüchtige Pufferspeicherbereich gelöscht.

Bei nicht-flüchtigen Pufferspeichern nimmt das Löschen der Daten eine beträchtlich Zeit in Anspruch. Da erfindungsgemäß dieses Löschen am Ende eines Speicherzyklus durchgeführt wird, fällt die dafür benötigte Zeit nicht ins Gewicht, da die Daten, die zu speichern sind, im Zielspeicherbereich bereits vorliegen. Andererseits kann das Löschen des nicht-flüchtigen Pufferspeicherbereichs dazu verwendet werden, gewissermaßen automatisch und ohne zusätzlichen Aufwand eine Qualitätskontrolle des gesamten Speichervorgangs zu erreichen. Ein vollständig gelöschter Pufferspeicherbereich zeigt einen erfolgreichen Abschluß eines Speichervorgangs an, während, wenn der Pufferspeicherbereich nicht vollständig gelöscht ist, dies darauf hindeutet, daß Probleme aufgetreten sind, und der Speichervorgang eventuell noch einmal wiederholt werden muß.

Vorzugsweise wird daher, bevor in einem darauffolgenden Zyklus wieder Daten in dem nicht-flüchtigen Pufferspeicherbereich abgespeichert werden, eine Überprüfung dahingehend durchgeführt, ob der Pufferspeicherbereich leer ist, oder ob sich in dem Pufferspeicherbereich Daten befinden, die eigentlich nicht dort sein sollen, so daß keine anschließenden Speichervorgänge durchgeführt werden, wenn der vorausgehende Speichervorgang nicht korrekt mit einem vollständig gelöschten Pufferspeicherbereich abgeschlossen worden ist.

Ein Vorteil der vorliegenden Erfindung besteht darin, daß der gesamte Speicherzyklus jederzeit vollständig rekonstruiert werden kann. Die Daten in dem Zielspeicherbereich werden erst gelöscht, wenn die Daten in dem Pufferspeicherbereich, der nicht-flüchtig ist und daher nicht anfällig ist, abgespeichert worden sind. Wird dagegen die Abspeicherung in den nicht-flüchtigen Pufferspeicherbereich nicht erfolgreich durchgeführt, so wird dies durch die Überprüfung erkannt, und das Abspeichern der Daten in den nicht-flüchtigen Pufferspeicherbereich kann einfach wiederholt werden. Somit wird bereits früh im Speicherzyklus eine Qualitätskontrolle durchgeführt, die die einzige notwendige Qualitätskontrolle ist, da ab diesem Zeitpunkt, wenn der Zielspeicherbereich ebenfalls ein nicht-flüchtiger Speicher ist, alle interessierenden Daten nur noch in nicht-flüchtigen Speichern und damit abgesichert vorliegen. Keine Programmierung von Flags und keine weitergehenden Absicherungen der nicht-flüchtigen Flags selbst sind noch erforderlich. Außerdem muß keine Überprüfung durchgeführt werden, bevor die Daten von dem Pufferspeicherbereich in den Zielspeicherbereich übertragen werden, da der Pufferspeicher ein nicht-flüchtiger Speicher ist und somit gegenüber Spannungseinbrüchen immun ist.

Selbstverständlich kann auch bei Bedarf vor dem Abspeichern der Daten vom Pufferspeicher in den Zielspeicher eine Überprüfung durchgeführt werden. Dieselbe kann jedoch weniger aufwendig und beispielsweise stichprobenartig durchgeführt werden, um zusätzlich die Qualität des nicht-flüchtigen Pufferspeicherbereichs beurteilen zu können. Solche Uberprüfungen können jedoch erfindungsgemäß wesentlich weniger aufwendig und seltener gestaltet werden, da die Datenintegrität nicht derart durchgreifend überprüft werden muß, wie in dem Fall, in dem Puffer als flüchtiger Speicher ausgestaltet ist.

Ein weiterer Vorteil der vorliegenden Erfindung besteht darin, daß lediglich durch sequentielles Ausführen der verschiedenen Vorgänge ein Speichervorgang geschaffen wird, der einerseits sicher ist, und der andererseits ohne nicht-flüchtige Flags auskommen kann, die einen Programmieraufwand nach sich ziehen. Insbesondere wird durch Überprüfen, ob der nicht-flüchtige Pufferspeicherbereich gelöscht ist, eine automatische Qualitätskontrolle des Gesamtspeicherzyklus erhalten, die zeitlich nicht ins Gewicht fällt, da die Daten bereits vorher in dem Zielspeicherbereich zur Verfügung stehen. Erfindungsgemäß stehen daher die im Zielspeicherbereich abgespeicherten Daten bereits zur Verfügung, bevor der gesamte Speicherzyklus durch das Löschen des nicht-flüchtigen Pufferspeicherbereichs abgeschlossen ist.

Bevorzugte Ausführungsbeispiele der vorliegenden Erfindung werden nachfolgend bezugnehmend auf die beiliegenden Zeichnungen detailliert erläutert. Es zeigen:
- Fig. 1: ein Blockschaltbild eines erfindungsgemäßen Speichersystems;
- Fig. 2: ein Flußdiagramm des erfindungsgemäßen Verfahrens zum Einspeichern einer Datenmenge in einen Zielspeicherbereich gemäß der vorliegenden Erfindung.

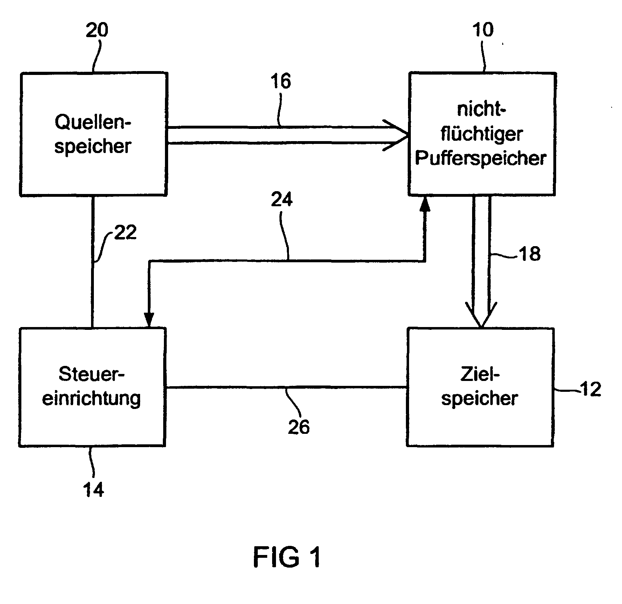

Fig. 1 zeigt ein erfindungsgemäßes Speichersystem mit einem nicht-flüchtigen Pufferspeicher 10, einem Zielspeicher 12 und einer Steuereinrichtung 14. Der nicht-flüchtige Pufferspeicher 10 kann über einen Datenbus 16 von einem Quellenspeicher mit Daten versorgt werden. Ferner existiert ein weiterer Datenbus 18 zwischen dem nicht-flüchtigen Pufferspeicher 10 und dem Zielspeicher 12. Für die vorliegende Erfindung wird jedoch kein Datenbus unmittelbar zwischen einem Quellenspeicher 20 und dem Zielspeicher 12 vorgesehen sein. Es sei jedoch darauf hingewiesen, daß für Speichervorgänge, bei denen es nicht so sehr auf die Sicherheit ankommt, auch Daten unmittelbar vom Quellenspeicher 20 zum Zielspeicher 12 übertragen werden können, beispielsweise in einem Schnellspeichermodus, bei dem Kompromisse hinsichtlich der Sicherheit eingegangen werden.

Die Steuereinrichtung 14 steht ferner über Steuerleitungen 22, 24 und 26 mit dem Quellenspeicher 20, dem nicht-flüchtigen Pufferspeicher 10 bzw. dem Zielspeicher 12 in Verbindung, um z. B. Adressierungen vornehmen zu können, um Überprüfungen im nicht-flüchtigen Pufferspeicher 10 vornehmen zu können, oder um beispielsweise einfache Rückmeldungen über bestimmte Vorgänge erhalten zu können.

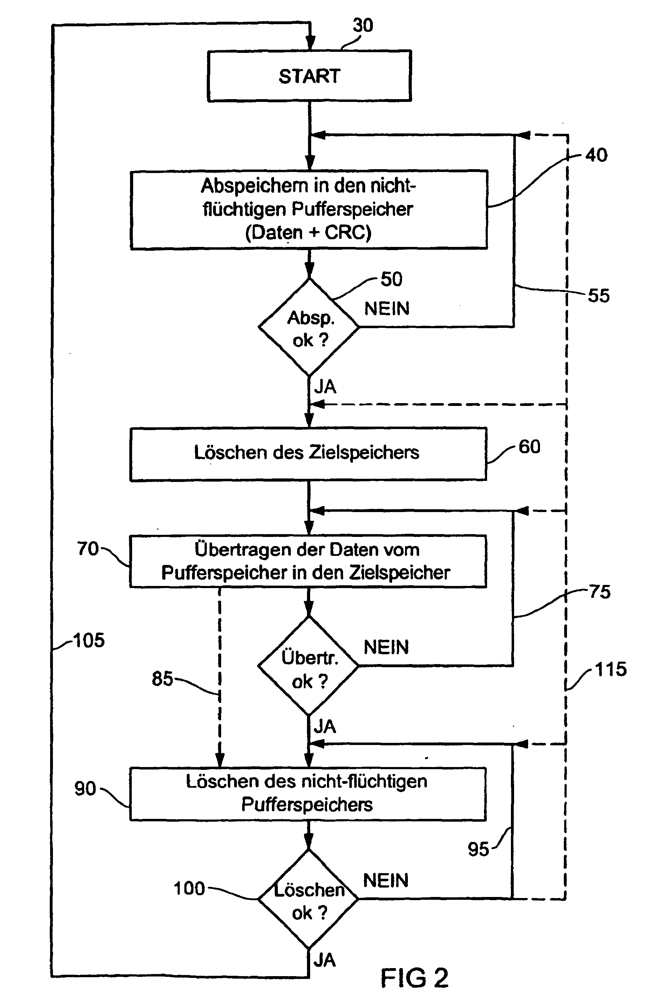

Fig. 2 zeigt ein Flußdiagramm, das von der Steuereinrichtung 14 gemäß der vorliegenden Erfindung ausgeführt wird, um eine Datenmenge von dem Quellenspeicher 20 in den Zielspeicher 12 zu übertragen. Nach einem Start-Block 30 wird zunächst die Datenmenge in den nicht-flüchtigen Pufferspeicher 10 eingespeist (40). Anschließend wird in einem Entscheidungsblock 50 überprüft, ob das Abspeichern in Ordnung war oder nicht. War das Abspeichern nicht in Ordnung, trat also während des Abspeicherns oder an irgend einem anderen Punkt ein Problem auf, so wird eine Schleife 55 durchlaufen, um den Abspeichervorgang (Block 40) zu wiederholen. Wird dagegen in dem Block 50 bestimmt, daß das Abspeichern in den nicht-flüchtigen Pufferspeicher in Ordnung war, so wird zu einem Block 60 gesprungen, in dem die Steuereinrichtung 14 den Zielspeicherbereich löscht, in den die einzuspeichernden Daten, die sich ja mittlerweile im nicht-flüchtigen Pufferspeicher 10 (Fig. 1) befinden, eingeschrieben werden sollen. Hierauf werden die Daten von dem Pufferspeicher in den Zielspeicher übertragen (Block 70). In einem Block 80 kann wahlweise festgestellt werden, ob diese Übertragung in Ordnung war. Wird diese Frage mit Nein beantwortet, so wird der Schritt 70 mittels einer Schleife 75 wiederholt. Wird dagegen festgestellt, daß die Übertragung in Ordnung war, so wird zu einem Block 90 gesprungen, in dem der nicht-flüchtige Pufferspeicher gelöscht wird. Alternativ kann, wie es bereits ausgeführt worden ist, von dem Block 70 direkt zum Block 90 übergegangen werden, wie es durch einen gestrichelten Pfeil 85 angedeutet ist, was insofern ohne großes Risiko möglich ist, da der Pufferspeicher ein nicht-flüchtiger Speicher ist.

Mit Abschluß des Blocks 90 ist ein Speicherzyklus beendet. Entweder im Anschluß an den Speicherzyklus oder erst vor der Ausführung eines neuen Speicherzyklus kann in einem Block 100 überprüft werden, ob der nicht-flüchtige Pufferspeicherbereich (10 in Fig. 1) vollständig gelöscht ist oder nicht. Wird diese Frage mit Ja beantwortet, so kann über eine Schleife 105 zu dem Start-Block 30 gesprungen werden, um mit dem Abspeichern einer neuen Datenmenge zu beginnen, da die "alte" Datenmenge erfolgreich im Zielspeicher, welcher vorzugsweise ein nicht-flüchtiger Speicher ist, abgespeichert worden ist. Wird dagegen die Frage im Block 100 mit Nein beantwortet, so kann über eine Schleife 95 das Löschen des nicht-flüchtigen Pufferspeichers noch einmal wiederholt werden. Diese Vorgehensweise ist dann sinnvoll, wenn die Überprüfung durch den Block 80 ausgeführt worden ist.

Wurde diese Überprüfung nicht ausgeführt, so kann über optionale Schleifen, die in Fig. 2 durch gestrichelte Linien 115 dargestellt sind, zu jedem anderen Block zurückgesprungen werden, um eventuelle Fehler im Speicherzyklus zu beheben. Während ein Rücksprung zum Block 40 nicht unbedingt erforderlich ist, da im Block 50 bereits festgestellt worden ist, ob das Abspeichern im Zielspeicherbereich ok war, empfiehlt sich hier ein Rücksprung zum Block 60 oder zum Block 70. Die Überprüfung im Block 100, also ob der nicht-flüchtige Pufferspeicher 10 vollständig gelöscht ist und für eine neue Datenübertragung zur Verfügung steht, liefert somit automatisch und ohne zusätzliche Flags und dergleichen eine insgesamte Qualitätskontrolle für den Speicherzyklus. Daher kann es im Sinne der Effizienz durchaus sinnvoll sein, aus Sicherheitsgründen den gesamten Speichervorgang noch einmal zu wiederholen und zum Schritt 40 zurück zu springen, anstatt die Stelle genau zu rekonstruieren, an der ein Fehler aufgetreten ist.

Erfindungsgemäß werden die zu übertragenden Informationen in dem nicht-flüchtigen Pufferspeicher 10 (Fig. 1) abgelegt, wobei jeder Information ein bestimmter Speicherbereich im Zielspeicher 12 zugeordnet ist. Diese Zuordnung kann erfindungsgemäß durch der Datenmenge zugeordnete Zusatzinformationen in dem nicht-flüchtigen Pufferspeicher 10 direkt abgespeichert werden, so daß die Steuereinrichtung 14 selbst keine Tabelle halten muß, in der ausgeführt ist, wo die Daten aus dem Quellenspeicher 20 in dem Zielspeicher 12 zu speichern sind. Vorzugsweise wird daher beim Start eines Speichervorgangs ein String in dem nicht-flüchtigen Pufferspeicher nicht flüchtig gespeichert, der die zu speichernden Informationen voll kennzeichnet. Dieser String enthält üblicherweise die Daten selbst, die Adresse unter der sie abgespeichert werden sollen, die Anzahl der Bytes und eine Prüfsumme beispielsweise in Form eines CRC (CRC = Cyclic Redundancy Check) über den Informationsinhalt des Strings. Der Schritt des Überprüfens, ob die Daten erfolgreich in dem nicht-flüchtigen Pufferspeicherbereich abgespeichert worden sind, kann dann, wenn eine CRC ebenfalls abgespeichert wird, einfach dadurch durchgeführt werden, daß die Prüfsumme aus den in dem Pufferspeicherbereich abgespeicherten Daten berechnet wird und mit der ebenfalls abgespeicherten Prüfsumme verglichen wird. Stimmen beide Prüfsummen überein, so kann davon ausgegangen werden, daß die Daten in dem nicht-flüchtigen Pufferspeicher korrekt angekommen sind.

Anschließend wird der Zielspeicher 12 gelöscht, woraufhin die Informationen des Pufferspeichers in den Zielspeicher geschrieben werden. Alternativ können die Zusatzdaten ebenfalls in den Zielspeicher geschrieben werden, um eine erneute Überprüfung durchzuführen. Dies ist jedoch nicht unbedingt notwendig, da keine Datenverluste in dem Pufferspeicher zu erwarten sind, da derselbe ein nicht-flüchtiger Speicher ist, und somit von sicheren Verhältnissen ausgegangen werden kann, wenn die Daten erst einmal korrekt im nicht-flüchtigen Pufferspeicher angekommen sind.

Abschließend wird der nicht-flüchtige Pufferspeicher 10 gelöscht. Die Programmiervorgänge erfolgen dabei vorzugsweise vollständig sequentiell, wobei der nächste Programmiervorgang jeweils erst dann gestartet wird, wenn der vorhergehende vollständig und erfolgreich abgeschlossen ist. Insgesamt besteht der erfindungsgemäße Speichervorgang damit aus vier zu programmierenden Vorgängen und einer Überprüfung im Gegensatz zu den zwei Vorgängen, die für einen Speichervorgang ohne Absicherung erforderlich wären. Der erfindungsgemäße Aufwand ist jedoch immer noch erheblich geringer als wenn beispielsweise Programmierungen von Flags erforderlich sind.

Der erfindungsgemäße Ablauf ist dahingehend vorteilhaft, daß der Speichervorgang jederzeit vollständig rekonstruiert werden kann, sobald nur die erste Programmierung, also die Übertragung der Daten vom Quellenspeicher in den nicht-flüchtigen Pufferspeicher erfolgreich abgeschlossen ist. Kann dieselbe nicht erfolgreich beendet werden, so ist auf jeden Fall die alte Information ohne das Risiko einer Beeinträchtigung verfügbar, da der Zielspeicherbereich 12 noch nicht angetastet worden ist.

Nachdem der Speicherzyklus erfindungsgemäß immer mit einem Löschen des Pufferspeichers 10 abgeschlossen wird, signalisiert ein vom gelöschten Zustand abweichender Wert des Pufferspeichers immer einen nicht erfolgreichen Speichervorgang. Wie es bereits bezugnehmend auf Fig. 2 ausgeführt worden ist, kann eine in der Steuereinrichtung 14 (Fig. 1) potentiell vorgesehene Software oder Firmware die nötigen Schritte unternehmen, um den gestörten Vorgang korrekt zu Ende zu führen oder vollständig zu wiederholen. Im einzelnen bedeutet dies folgendes. Wird ohne Kenntnis des Vorgeschichte, z. B. nach einem Spannungsabfall, oder zu Beginn einer Abspeicherungsaufgabe mit einem Speichern begonnen, so wird es bevorzugt, vor dem Schritt des Abspeicherns (40) in einem nicht-flüchtigen Pufferspeicherbereich, eine Überprüfung (100) dahingehend durchzuführen, ob der nicht-flüchtige Pufferspeicherbereich (10) vollständig gelöscht ist.

Ist dies nicht der Fall, wird anhand der CRC der im Pufferspeicherbereich noch vorhandenen Daten überprüft (50), ob eine Datenmenge erfolgreich in dem nicht-flüchtigen Pufferspeicherbereich abgespeichert ist. Wird dies bestätigt, z. B. durch Übereinstimmung der CRC mit den Daten, so wird die Speicherroutine mit dem Schritt des Löschens (60) des Zielspeicherbereichs fortgesetzt, wie es in Fig. 2 dargestellt ist. Wird jedoch festgestellt, daß die Daten im Pufferspeicherbereich nicht zu der CRC passen, also offensichtlich beschädigt oder nicht sinnvoll sind, so wird ein ganz neuer Speicherzyklus begonnen, indem zunächst die nicht sinnvollen Daten im Pufferspeicherbereich gelöscht werden und dann zum Block Start 30 in Fig. 2 bzw. zum Block 40 in Fig. 2 gesprungen wird.

### Bezugszeichenliste

Verfahren zum Einspeichern einer Datenmenge in einen Zielspeicherbereich und Speichersystem
- 10: nicht-flüchtiger Pufferspeicher
- 12: Zielspeicher
- 14: Steuereinrichtung
- 16: Datenleitung
- 18: Datenleitung
- 20: Quellenspeicher
- 22: Steuerleitung
- 24: Steuerleitung
- 26: Steuerleitung
- 30: Start
- 40: Abspeichern in den Pufferspeicher
- 50: Abspeichern ok?
- 55: Schleife
- 60: Löschen des Zielspeichers
- 70: Übertragen der Daten von dem Pufferspeicher
- 75: Schleife
- 80: Übertragung ok
- 85: Direktwegpfeil
- 90: Löschen des Pufferspeichers
- 95: Schleife
- 100: Löschen ok?
- 105: Schleife

## Patentansprüche

1. Verfahren zum Einspeichern einer Datenmenge in einen Zielspeicherbereich (12), mit folgenden Schritten:
Abspeichern (40) der Datenmenge in einem nicht-flüchtigen Pufferspeicherbereich (10);
überprüfen (50), ob die Datenmenge erfolgreich in dem nicht-flüchtigen Pufferspeicherbereich (10) abgespeichert ist;
wenn der Schritt des Überprüfens (50) ein positives Ergebnis liefert, Löschen (60) des Zielspeicherbereichs (12), in den die vorbestimmte Menge von Daten eingespeichert werden soll;
nach dem Schritt des Löschen des Zielspeicherbereichs, Übertragen (70) der Daten von dem nicht-flüchtigen Pufferspeicherbereich in den Zielspeicherbereich (12); und
Löschen (90) des nicht-flüchtigen Pufferspeicherbereichs (10).

2. Verfahren nach Anspruch 1, bei dem im Schritt des Abspeicherns (40) ein Datensatz in den nicht-flüchtigen Pufferspeicherbereich (10) abgespeichert wird, der einen Prüfcode umfaßt, anhand dessen die Integrität der Daten in dem Schritt des Überprüfens (50) überprüft wird.

3. Verfahren nach Anspruch 1 oder Anspruch 2, bei dem im Schritt des Abspeicherns ein Datensatz in dem nicht-flüchtigen Pufferspeicherbereich (10) abgespeichert wird, der Größeninformationen über die Datenmenge umfaßt, die im Schritt des Übertragens verwendet wird, um einen ausreichend großen Zielspeicherbereich zuzuweisen.

4. Verfahren nach einem der vorhergehenden Ansprüche,
bei dem im Schritt des Abspeicherns (40) ein Datensatz in dem nicht-flüchtigen Pufferspeicherbereich abgespeichert wird, der eine Zieladressinformation umfaßt, die im Schritt des Übertragens (70) verwendet wird, die Daten an einer vorbestimmten Stelle des Zielspeicherbereichs (12) abzuspeichern.

5. Verfahren nach einem der vorhergehenden Ansprüche, das ferner folgende Schritte aufweist:
vor dem Schritt des Abspeicherns (40) in einem nicht-flüchtigen Pufferspeicherbereich, Überprüfen (100), ob der nicht-flüchtige Pufferspeicherbereich (10) vollständig gelöscht ist, und, falls dies nicht der Fall ist, Überprüfen (50), ob die Datenmenge erfolgreich in dem nicht-flüchtigen Pufferspeicherbereich abgespeichert ist, und, wenn dies der Fall ist, Fortfahren mit dem Schritt des Löschens (60) des Zielspeicherbereichs, und, falls dies nicht der Fall ist, Löschen (90) des nicht-flüchtigen Pufferspeicherbereichs und Fortfahren mit dem Schritt des Abspeicherns (40).

6. Verfahren nach einem der Ansprüche 1 bis 4, bei dem vor dem Schritt des Abspeicherns (40) überprüft wird, *ob der* nicht-flüchtige Pufferspeicherbereich (10) gelöscht ist (100), und bei dem der Schritt des Abspeicherns (40) nur dann ausgeführt wird, wenn der nicht-flüchtige Pufferspeicherbereich (10) vollständig gelöscht ist.

7. Verfahren nach einem der vorhergehenden Ansprüche, bei dem nach dem Schritt des Übertragens (70) der folgende Schritt ausgeführt wird:
Überprüfen (80), ob im Schritt des Übertragens die Daten erfolgreich von dem nicht-flüchtigen Pufferspeicherbereich in den Zielspeicherbereich übertragen worden sind, und
wobei der Schritt des Löschens (90) des nicht-flüchtigen Pufferspeicherbereichs erst dann durchgeführt wird, wenn der Schritt des Übertragens (80) erfolgreich war.

8. Verfahren nach Anspruch 5, das ferner folgende Schritte aufweist:
Überprüfen (80), ob im Schritt des Übertragens die Daten erfolgreich von dem nicht-flüchtigen Pufferspeicherbereich in den Zielspeicherbereich übertragen worden sind, und
wobei der Schritt des Löschens (90) des nicht-flüchtigen Pufferspeicherbereichs nur dann durchgeführt wird, wenn der Schritt des Überprüfens (80) erfolgreich war, und
wobei der Schritt des Löschens (60) des Zielspeicherbereichs und der Schritt des Übertragens (70) der Daten von dem Pufferspeicherbereich in den Zielspeicherbereich nur dann durchgeführt wird, wenn der Schritt des Überprüfens (80) nicht erfolgreich war.

9. Speichersystem mit folgenden Merkmalen:
einem nicht-flüchtigen Pufferspeicherbereich (10) ;
einem Zielspeicherbereich (12); und
einer Steuereinrichtung (14), die ausgebildet ist, um folgende Schritte auszuführen:
Abspeichern (40) der Datenmenge in einem nicht-flüchtigen Pufferspeicherbereich (10);
überprüfen (50), ob die Datenmenge erfolgreich in dem nicht-flüchtigen Pufferspeicherbereich (10) abgespeichert ist;
wenn der Schritt des Überprüfens (50) ein positives Ergebnis liefert, Löschen (60) des Zielspeicherbereichs (12), in den die vorbestimmte Menge von Daten eingespeichert werden soll;
nach dem Schritt des Löschen des Zielspeicherbereichs, Übertragen (70) der Daten von dem nicht-flüchtigen Pufferspeicherbereich in den Zielspeicherbereich (12); und
Löschen (90) des nicht-flüchtigen Pufferspeicherbereichs (10).

## Claims

1. A method of storing a quantity of data into a target memory location (12), comprising the steps of:
storing (40) the quantity of data into a non-volatile buffer memory location (10);
examining (50) whether the quantity of data is successfully stored in the non-volatile buffer memory location (10);
if the step of examining (50) delivers a positive result, clearing (60) the target memory location (12) into which the predetermined quantity of data is to be stored;
after the step of clearing the target memory location, transferring (70) the data from the non-volatile buffer memory location to the target memory location (12); and
clearing (90) the non-volatile buffer memory location (10).

2. A method according to claim 1, wherein the step of storing (40) comprises storing of a record in the non-volatile buffer memory location (10), said record comprising a check code by means of which the integrity of the data is examined in said step of examining (50).

3. A method according to claim 1 or claim 2, wherein the step of storing comprises storing of a record in the non-volatile buffer memory location (10), said record comprising size information on the quantity of data used in said step of transferring, in order to allocate a sufficiently large target memory location.

4. A method according to any of the preceding claims, wherein the step of storing (40) comprises storing of a record in the non-volatile buffer memory location, said record comprising target address information that is utilized in said step of transferring (70) for storing the data at a predetermined point of said target memory location (12).

5. A method according to any of the preceding claims, further comprising the following steps:
prior to said step of storing (40) in the non-volatile buffer memory location, examining (100) whether the non-volatile buffer memory location (10) is cleared completely and, if this is not the case, examining (50) whether the quantity of data is successfully stored in the non-volatile buffer memory location and, if this is the case, continuing with said step of clearing (60) the target memory location and, if this is not the case, clearing (90) the non-volatile buffer memory location and continuing with said step of storing (40).

6. A method according to any of claims 1 to 4, wherein, prior to said step of storing (40), it is examined whether the non-volatile buffer memory location (10) is cleared (100), and wherein said step of storing (40) is carried out only if the non-volatile buffer memory location (10) is cleared completely.

7. A method according to any of the preceding claims, wherein the step of transferring (70) is followed by the following step:
examining (80) whether the data have been successfully transferred from the non-volatile buffer memory location to the target memory location in said step of transferring, and
wherein the step of clearing (90) the non-volatile buffer memory location is carried out only after the step of transferring (80) has been successful.

8. A method according to claim 5, further comprising the following steps:
examining (80) whether the data have been successfully transferred from the non-volatile buffer memory location to the target memory location in said step of transferring, and
wherein the step of clearing (90) the non-volatile buffer memory location is carried out only if the step of examining (80) was successful, and
wherein the step of clearing (60) the target memory location and the step of transferring (70) the data from the buffer memory location to the target memory location are carried out only if the step of examining (80) was not successful.

9. A storage system, comprising:
a non-volatile buffer memory location (10);
a target memory location (12); and
a control means (14) designed to carry out the following steps:
storing (40) the quantity of data in a non-volatile buffer memory location (10);
examining (50) whether the quantity of data is successfully stored in the non-volatile buffer memory location (10);
if the step of examining (50) provides a positive result, clearing (60) the target memory location (12) into which the predetermined quantity of data is to be written;
subsequent to the step of clearing the target memory location, transferring (70) the data from the non-volatile buffer memory location to the target memory location (12); and
clearing (90) the non-volatile buffer memory location (10).

## Revendications

1. Procédé pour mettre en mémoire une quantité de données dans une zone (12) de mémoire cible, comportant les étapes suivantes :
on met en mémoire (40) la quantité de données dans une zone (10) de mémoire tampon non volatile ;
on vérifie (50) si la quantité de données est mise en mémoire avec succès dans la zone (10) de mémoire tampon non volatile ;
si l'étape de la vérification (50) fournit un résultat positif, on efface (60) la zone (12) de mémoire cible dans laquelle la quantité prédéterminée de données doit être mise en mémoire ;
après l'étape de l'effacement de la zone de mémoire cible, on transfert (70) les données de la zone de mémoire tampon non volatile à la zone (12) de mémoire cible ; et
on efface (90) la zone (10) de mémoire tampon non volatile.

2. Procédé suivant la revendication 1, dans lequel, à l'étape de la mise en mémoire (40), on met en mémoire dans la zone (10) de mémoire tampon non volatile un lot de données qui comprend un code de vérification à l'aide duquel on vérifie l'intégrité des données à l'étape de la vérification (50).

3. Procédé suivant la revendication 1 ou la revendication 2, dans lequel, à l'étape de la mise en mémoire, on met en mémoire dans la zone (10) de mémoire tampon non volatile un lot de données qui comprend des informations de grandeur sur la quantité de données qui est utilisée à l'étape du transfert afin d'affecter une zone de mémoire cible suffisamment grande.

4. Procédé suivant l'une des revendications précédentes, dans lequel, à l'étape de la mise en mémoire (40), on met en mémoire dans la zone de mémoire tampon non volatile un lot de données qui comprend une information d'adresse cible qui est utilisée à l'étape du transfert (70), afin de mettre en mémoire les données à un endroit prédéterminé de la zone (12) de mémoire cible.

5. Procédé suivant l'une des revendications précédentes, qui comporte de plus des étapes suivantes :
avant l'étape de la mise en mémoire (40) dans une zone de mémoire tampon non volatile, on vérifie (100) si la zone (10) de mémoire tampon non volatile est totalement effacée et, dans le cas où ce n'est pas le cas, on vérifie (50) si la quantité de données est mise en mémoire avec succès dans la zone de mémoire tampon non volatile et, si ce n'est pas la cas, on poursuit par l'étape d'effacement (60) de la zone de mémoire cible et, dans le cas où ce n'est pas le cas, on efface (90) la zone de mémoire tampon non volatile et on poursuit par l'étape de la mise en mémoire (40).

6. Procédé suivant l'une des revendications 1 à 4, dans lequel, avant l'étape de la mise en mémoire (40), on vérifie si la zone (10) de mémoire tampon non volatile est effacée (100) et dans lequel on n'exécute l'étape de la mise en mémoire (40) que si la zone (10) de mémoire tampon non volatile est totalement effacée.

7. Procédé suivant l'une des revendications précédentes, dans lequel on exécute, après l'étape du transfert (70), l'étape suivante :
on vérifie (80) si à l'étape du transfert les données ont été transférées avec succès de la zone de mémoire tampon non volatile à la zone de mémoire cible, et l'étape de l'effacement (90) de la zone de mémoire tampon non volatile n'étant exécutée que si l'étape du transfert (80) a été effectuée avec succès.

8. Procédé suivant la revendication 5, qui comporte de plus des étapes suivantes :
on vérifie (80) si, à l'étape du transfert, les données ont été transférées avec succès de la zone de mémoire tampon non volatile à la zone de mémoire cible, et
l'étape de l'effacement (90) de la zone de mémoire tampon non volatile n'étant exécutée que si l'étape du transfert (80) s'est effectuée avec succès, et
l'étape de l'effacement (60) de la zone de mémoire cible et l'étape du transfert (70) des données de la zone de mémoire tampon à la zone de mémoire cible n'étant exécutée que si l'étape du transfert (80) n'a pas été effectuée avec succès.

9. Système de mise en mémoire comportant les caractéristiques suivantes :
une zone (10) de mémoire tampon non volatile ;
une zone (12) de mémoire cible ; et
un dispositif (14) de commande qui est réalisé pour exécuter des étapes suivantes :
mise en mémoire (40) de la quantité de données dans une zone (10) de mémoire tampon non volatile ;
vérification (50) pour savoir si la quantité de données a été mise en mémoire avec succès dans la zone (10) de mémoire tampon non volatile ;
si l'étape de la vérification (50) fournit un résultat positif, effacement (60) de la zone (12) de mémoire cible dans laquelle la quantité prédéterminée de données doit être mise en mémoire ;
après l'étape de l'effacement de la zone de mémoire cible, transfert (70) des données de la zone de mémoire tampon non volatile à la zone (12) de mémoire cible ; et
effacement (90) de la zone (10) de mémoire tampon non volatile.
